**Europäisches Patentamt**

**European Patent Office**

**Office européen des brevets**

(19)

(11) Numéro de publication : **0 462 040 A1**

(12) # DEMANDE DE BREVET EUROPEEN

(21) Numéro de dépôt : **91460028.3**

(22) Date de dépôt : **17.05.91**

(51) Int. Cl.⁵ : **H01L 29/784, H01L 29/60, H01L 27/02**

(30) Priorité : **17.05.90 FR 9006408**

(43) Date de publication de la demande : **18.12.91 Bulletin 91/51**

(84) Etats contractants désignés : **DE GB IT NL**

(71) Demandeur : **HELLO S.A. 137 boulevard de Sébastopol F-75002 Paris (FR)**

(72) Inventeur : **Compagne, Eric 91, Grand Rue F-38700 La Tronche (FR)**

(74) Mandataire : **Corlau, Vincent et al c/o Cabinet Vidon Immeuble Germanium 80 avenue des Buttes de Coesmes F-35700 Rennes (FR)**

(54) **Transistor MOS à tension de seuil élevée.**

(57) La présente invention concerne un transistor MOS à tension de seuil élevée comprenant, dans un substrat semiconducteur (1) d'un premier type de conductivité, des régions superficielles de drain et de source (31, 32) du deuxième type de conductivité à haut niveau de dopage séparées par une zone d'oxyde épais (33) sous laquelle est formée, dans le substrat, une région surdopée (37) du premier type de conductivité. Chacune des régions de drain et de source est insérée dans un caisson (38) du deuxième type de conductivité à faible niveau de dopage formé dans le substrat. Ce transistor permet de réaliser une diode de protection. De plus, la partie supérieure de chacun desdits caissons (38) comprend, sous ladite zone d'oxyde épais (33), entre chacune desdites régions de drain et de source (31,32) et la région surdopée (37), une région (39) dudit deuxième type de conductivité à niveau de dopage moyen.

De cette façon, on ne trouve plus aucune transition entre zones de types de conductivité opposés à très fort gradient de dopage.

Fig. 2

EP 0 462 040 A1

La présente invention concerne la réalisation dans un circuit intégré d'un transistor MOS à tension de seuil élevée. ·

Dans un circuit intégré de type MOS, on forme de très nombreux transistors MOS logiques qui ont couramment des tensions de seuil de l'ordre de quelques volts. Il peut toutefois être utile dans un tel circuit de disposer de transistors MOS à tension de seuil nettement plus élevée, de l'ordre de quelques dizaines de volts, par exemple pour servir de diodes de protection d'entrée. De tels transistors s'avèrent également nécessaires pour la réalisation de transistors de sortie d'un circuit devant supporter en permanence des tensions de fonctionnement sur son drain et sa grille supérieures aux tensions d'alimentation du circuit.

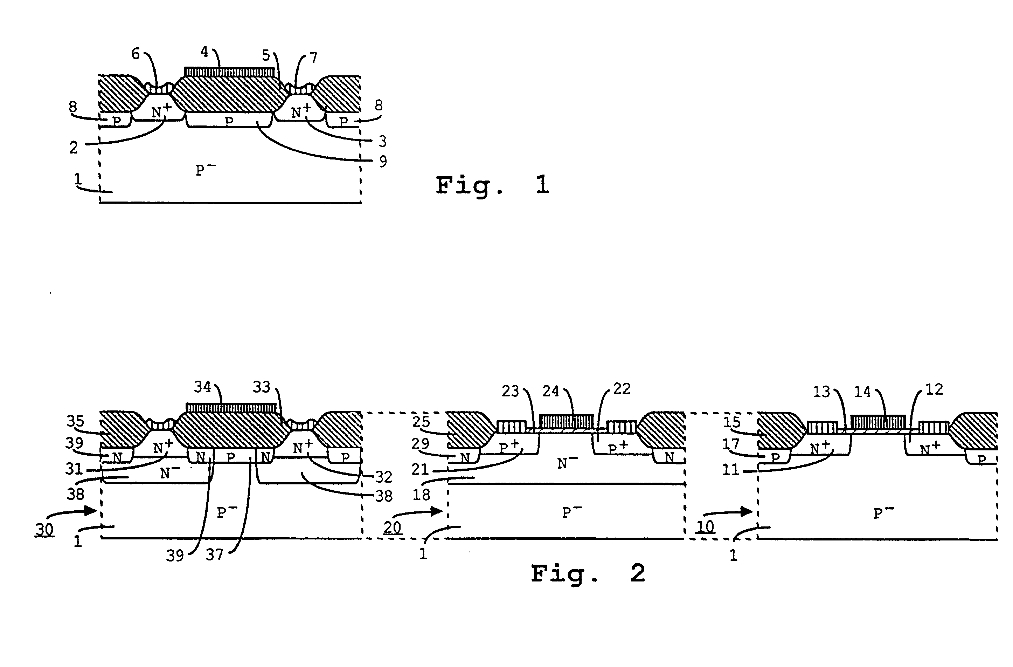

Pour réaliser des transistors MOS à tension de seuil élevée, on a utilisé dans l'art antérieur des structures telles que celle illustrée schématiquement en figure 1. Cette figure représente un transistor MOS comprenant, dans un substrat semi-conducteur 1 de type P⁻, une région de source 2 et une région de drain 3 de type N⁺. La grille 4 est formée sur une zone d'oxyde épais, ou zone d'oxyde de champ 5, correspondant aux zones d'oxyde normalement prévues pour séparer les uns des autres des transistors MOS d'un circuit intégré. On a également illustré une métallisation de source 6 et une métallisation de drain 7. Des régions d'arrêt de canal 8 de type P sont formées sous les régions d'oxyde épais externes au transistor à tension de seuil élevée ainsi qu'une région surdopée 9, correspondant à ces régions d'arrêt de canal, sous l'oxyde épais de grille 4.

Pour former un dispositif de protection, ce transistor MOS est connecté en diode, c'est-à-dire que le drain 3 et la grille 4 sont interconnectés, de même que la source et le substrat.

A priori, un transistor ayant la structure illustrée en figure 1 présente une tension de seuil élevée en raison de sa forte épaisseur de grille et de l'enrichissement de la région de canal. Cette tension de seuil peut, dans certaines technologies, être de l'ordre de 30 à 50 volts. Néanmoins, en pratique, ce transistor, connecté en diodes, présentera une tension de seuil beaucoup plus faible car c'est la jonction N⁺P⁻ (ou P⁻N⁺) entre le drain ou la source et le substrat qui claquera en premier, par exemple à une tension de l'ordre de 10 à 15 volts, si le substrat P⁻ présente un niveau de dopage de l'ordre de $10^{15}$ atomes/cm³ et les régions de drain et de source un niveau de dopage de l'ordre de $10^{20}$ at./cm³.

Ainsi, si l'on veut fabriquer en association avec un circuit intégré comprenant des transistors MOS complémentaires un transistor MOS à tension de seuil élevée, on est amené ou bien à réaliser des zones de niveau de dopage particulier, distinctes des zones utilisées ailleurs dans le circuit intégré, ce qui implique des étapes technologiques supplémentaires par rapport aux étapes normales de fabrication du circuit intégré, ou bien la réalisation d'un dispositif externe au circuit intégré. Ces deux solutions sont coûteuses.

Un objectif de la présente invention est de fournir un transistor MOS transistors MOS à tension de seuil élevée, ce transistor MOS pouvant être fabriqué dans un circuit intégré à transistors MOS complémentaires (CMOS) sans nécessiter d'étapes technologiques supplémentaires par rapport aux étapes de fabrication normales du circuit intégré CMOS.

Un autre objectif de l'invention est de fournir un tel transistor, limitant les risques de claquage des différentes jonctions, même en présence d'une tension de seuil élevée.

L'invention a également pour objectif de fournir un tel transistor, pouvant fonctionner en présence de tensions utiles élevées appliquées en permanence.

Pour atteindre ces objectifs, la présente invention prévoit un transistor MOS à tension de seuil élevée comprenant, dans un substrat semiconducteur d'un premier type de conductivité, des régions superficielles de drain et de source du deuxième type de conductivité à haut niveau de dopage séparées par une zone d'oxyde épais sous laquelle est formée, dans le substrat, une région surdopée du premier type de conductivité, chacune des régions de drain et de source étant insérée dans un caisson du deuxième type de conductivité à faible niveau de dopage formé dans le substrat, et dans laquelle la partie supérieure de chacun des caissons comprend, sous la zone d'oxyde épais, entre chacune des régions de drain et de source et la région surdopée, une région du deuxième type de conductivité à niveau de dopage moyen.

De cette façon, tous les risques de claquage des différentes jonctions existant dans le transistor sont évités, à l'aide de zones tampons de niveau de dopage intermédiaire. En d'autres termes, les zones de conductivité opposées à fort gradient de dopage sont isolées.

Un transistor selon la présente invention fait de préférence partie d'un circuit intégré comprenant des transistors MOS à canal du deuxième type de conductivité et des transistors MOS à canal du premier type de conductivité formés dans des caissons ménagés dans le substrat. En ce cas, les régions de drain et de source du transistor à tension de seuil élevée correspondent aux régions de drain et de source des transistors à canal du deuxième type de conductivité ; les caissons de drain et de source du transistor à tension de seuil élevée correspondent aux caissons des transistors MOS à canal du premier type de conductivité ; la région surdopée du prenier type de conductivité correspond à des régions d'arrêt de canal des transistors à canal du deuxième type de conductivité ; et les régions du deuxième type de conductivité à niveau de dopage moyen correspondent à des dopages d'arrêt de canal des transistors complémentaires.

Un des avantages d'une telle structure est que toutes les implantations, diffusions et oxydations nécessaires à la fabrication du transistor MOS à tension de seuil élevée selon l'invention sont des opérations qui sont de toute manière effectuées lors de la fabrication d'un circuit CMOS formé sur le même substrat que le transistor selon l'invention.

Ces transistors peuvent notamment être utilisés en entrée de circuit susceptible d'être soumise à des tensions utiles élevées, ou en sortie de circuit, supportant des tensions de fonctionnement supérieures à celles d'alimentation du circuit.

Ces objets, caractéristiques et avantages ainsi que d'autres de la présente invention seront exposés plus en détail dans la description suivante des modes de réalisation particuliers faite en relation avec les figures jointes parmi lesquelles :

– la figure 1, décrite précédemment, illustre un transistor MOS à tension de seuil élevée selon l'art antérieur ; et

– la figure 2 représente, en coupe schématique, des portions de circuit intégré dont la partie gauche correspond à un transistor MOS à tension de seuil élevée selon la présente invention.

Dans ces figures, on notera que, comme cela est usuel dans le domaine de la représentation des circuits intégrés, les dimensions horizontales et verticales des diverses couches ont été arbitrairement contractées ou dilatées pour faciliter la lisibilité des figures sans en augmenter excessivement l'encombrement.

La figure 2 représente des composants d'un circuit intégré parmi lesquels on a représenté, à droite, un transistor MOS à canal N classique 10, au centre, un transistor complémentaire à canal P classique 20 et, à gauche, un transistor MOS à tension de seuil élevée 30 selon la présente invention.

Tous ces transistors sont formés dans un substrat de silicium 1 de type P à faible niveau de dopage, marqué $P^-$, dont le niveau de dopage est par exemple de l'ordre de $10^{15}$ at./cm³.

Le transistor MOS à canal N 10 comprend, dans ce substrat P, des régions $N^+$ de drain et de source 11 et 12 séparées par une région de substrat au-dessus de laquelle et formé un oxyde mince de grille 13 et un conducteur de grille 14. Le transistor 10 est séparé de ses voisins par une région d'oxyde épais 15 sous laquelle est couramment formée une région d'arrêt de canal de type opposé aux régions de drain et de source, ici une région 17 de type P. A titre d'exemple, le niveau de dopage de la région 17 est de l'ordre de $10^{17}$ at./cm³ alors que les régions $N^+$ 11 et 12 de drain et de source présentent un niveau de dopage de l'ordre de $10^{20}$ at./cm³.

Le transistor complémentaire 20 à canal P est formé dans un caisson $N^-$ 18, lui-même formé dans le substrat 1. Ce caisson $N^-$ 18 présente par exemple un niveau de dopage de l'ordre de $5.10^{15}$ at./cm³. Il

comprend des régions de drain et de source 21 et 22 de type $P^+$, un oxyde mince d'isolement de grille 23 et un conducteur de grille 24. Des transistors adjacents sont séparés par une région d'oxyde épais 25 sous laquelle se trouve une couche d'arrêt de canal 29, de même type de conductivité (N) que le caisson et de type opposé aux régions de drain et de source 21 et 22. Dans un mode de réalisation classique, le caisson $N^-$ 17 aura un niveau de dopage de l'ordre de $5.10^{15}$ at./cm³, les régions d'arrêt de canal un niveau de dopage de l'ordre de $10^{17}$ at./cm³ et les régions de drain et de source 21 et 22 un niveau de dopage de l'ordre de $10^{20}$ at./cm³.

Le transistor 30 selon la présente invention, représenté à gauche de la figure 2, comprend des régions de drain et de source 31 et 32 séparées par une région de canal surmontée d'un oxyde épais 33 recouvert d'un conducteur de grille 34. L'oxyde épais 34 correspond à l'oxyde épais 35 d'isolement entre ce transistor et ses voisins. Dans la région de canal est formée une région surdopée de type P 37. Ainsi, comme le transistor illustré en figure 1, ce transistor MOS aura une tension de seuil élevée du fait que son isolant de grille est épais et que sa région de canal est enrichie. En outre, la présente invention prévoit de placer chacune des régions de drain et de source 31 et 32 dans un petit caisson 38 de type N faiblement dopé ($N^-$) entourant complètement les régions surdopées de drain et de source 31 et 32. Ainsi, on évite la création de diodes $N^+P^-$ susceptibles de présenter une tension de claquage en inverse plus faible que la tension de seuil du transistor.

Pour éviter le risque de claquage de la jonction $N^+P$ entre la région de drain/source 31, 32 et la région enrichie de canal 37, on forme à la surface du caisson 38 des régions 39 à niveau de dopage intermédiaire. Ainsi, dans la structure illustrée dans le transistor 30, on ne trouve plus aucune transition entre zones de types de conductivité opposés à très fort gradient de dopage.

Le transistor 30 selon l'invention peut être fabriqué sans impliquer aucune étape technologique supplémentaire par rapport à la fabrication des transistors MOS complémentaires 10 et 20. En effet, les régions de drain et de source 31 et 32 du transistor 30 correspondent aux régions de drain et de source 11 et 12 du transistor 10 ; les caissons $N^-$ 38 correspondent au caisson $N^-$ 18 du transistor 20 ; la zone d'enrichissement de canal 37 correspond à la zone d'arrêt de canal 17 du transistor 10 ; et la zone de type N à niveau de dopage intermédiaire 39 correspond à la zone d'arrêt de canal 29 du transistor 20. Des exemples de niveaux de dopage de ces diverses régions ont été indiqués précédemment.

Un tel transistor peut trouver de nombreuses applications dans les circuits intégrés. Il peut par exemple être utilisé :

– sur les entrées d'un circuit sur lesquelles des tensions utiles importantes peuvent être appliquées en permanence (fonctionnement en mode passif) ;

– sur les sorties d'un circuit, permettant de supporter des tensions de fonctionnement sur sa grille et sur son drain supérieures aux tensions d'alimentation du circuit (fonctionnement en mode actif) ;

– dans d'autres configurations, notamment à l'intérieur même d'un circuit.

Bien qu'un mode de réalisation particulier de la présente invention ait été décrit, l'homme de l'art pourra, sans sortir du domaine de l'invention, y apporter divers perfectionnements et modifications qui lui apparaîtront naturellement. Par exemple, tous les types de conductivité pourront être interchangés.

D'autre part, le conducteur de grille pourra correspondre à l'un des niveaux de silicium polycristallin ou de métallisation prévus dans la technologie de fabrication du circuit intégré. Il en résultera généralement des tensions de seuil différentes puisque l'épaisseur de la couche d'oxyde épais 33 sera différente dans ces différents cas.

**Revendications**

1. Transistor MOS à tension de seuil élevée comprenant, dans un substrat semiconducteur (1) d'un premier type de conductivité, des régions superficielles de drain et de source (31, 32) du deuxième type de conductivité à haut niveau de dopage séparées par une zone d'oxyde épais (33) sous laquelle est formée, dans le substrat, une région surdopée (37) dudit premier type de conductivité,

   caractérisé en ce chacune desdites régions de drain et de source est insérée dans un caisson (38) dudit deuxième type de conductivité à faible niveau de dopage formé dans ledit substrat,

   et en ce que la partie supérieure de chacun desdits caissons (38) comprend, sous ladite zone d'oxyde épais (33), entre chacune desdites régions de drain et de source (31,32) et la région surdopée (37), une région (39) dudit deuxième type de conductivité à niveau de dopage moyen.

2. Transistor selon la revendication 1, faisant partie d'un circuit intégré comprenant des transistors MOS (10) à canal du deuxième type de conductivité et des transistors MOS (20) à canal du premier type de conductivité formés dans des caissons ménagés dans le substrat, caractérisé en ce que :

   lesdites régions (31, 32) de drain et de source du transistor à tension de seuil élevée correspondent aux régions (11, 12) de drain et de source des transistors à canal du deuxième type de conductivité ;

   lesdits caissons de drain et de source (38) dudit transistor à tension de seuil élevée correspondent aux caissons (18) des transistors MOS à canal du premier type de conductivité ;

   ladite région surdopée de premier type de conductivité (37) correspond à des régions d'arrêt de canal (17) des transistors à canal du deuxième type de conductivité ; et

   lesdites régions du deuxième type de conductivité à niveau de dopage moyen (39) correspondent à des dopages d'arrêt de canal (29) des transistors complémentaires.

3. Utilisation d'un transistor selon l'une quelconque des revendications 1 et 2, pour l'entrée d'un circuit intégré sur laquelle des tensions utiles élevées sont susceptibles d'être appliquées en permanence.

4. Utilisation d'un transistor selon l'une quelconque des revendications 1 et 2, pour la sortie d'un circuit intégré devant supporter des tensions de fonctionnement sur sa grille et/ou son drain supérieures aux tensions d'alimentation dudit circuit intégré.

Fig. 1

Fig. 2

Office européen
des brevets

**RAPPORT DE RECHERCHE EUROPEENNE**

Numero de la demande

EP    91 46 0028

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | EP-A-0 217 525 (ADVANCED MICRO DEVICES, INC.)<br>* abrégé *<br>* colonne 6, ligne 18 - ligne 25; figure 2 *<br>* colonne 4, ligne 46 - colonne 5, ligne 18; figures 3A-3B *<br>--- | 1-4 | H01L29/784<br>H01L29/60<br>H01L27/02 |
| A | EP-A-0 161 983 (DIGITAL EQUIPMENT CORP.)<br>* abrégé; figures 1-2 *<br>--- | 1-4 | |
| A | PATENT ABSTRACTS OF JAPAN<br>vol. 11, no. 384 (E-565)(2831) 15 Décembre 1987<br>& JP-A-62 150 876 (HITACHI LTD ) 4 Juillet 1987<br>* le document en entier *<br>--- | 1-4 | |
| A | PATENT ABSTRACTS OF JAPAN<br>vol. 12, no. 184 (E-614)(3031) 28 Mai 1988<br>& JP-A-62 286 266 (TOSHIBA CORP. ) 12 Décembre 1987<br>* le document en entier *<br>--- | 1-4 | |
| A | US-A-4 692 781 (TEXAS INSTRUMENTS INC.)<br>* abrégé; figure 3 *<br>----- | 1-4 | **DOMAINES TECHNIQUES RECHERCHES (Int. Cl.5)**<br><br>H01L |

Le présent rapport a été établi pour toutes les revendications

| Lieu de la recherche | Date d'achèvement de la recherche | Examinateur |
|---|---|---|
| LA HAYE | 08 OCTOBRE 1991 | MIMOUN B.J. |

**CATEGORIE DES DOCUMENTS CITES**

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 

& : membre de la même famille, document correspondant

EPO FORM 1503 03.82 (P0402)